# EUROPÄISCHE PATENTSCHRIFT

(11) **EP 1 708 239 B1**
(45) Veröffentlichungstag und Bekanntmachung des Hinweises auf die Patenterteilung: **02.03.2011**
(21) Anmeldenummer: 05006876.6
(22) Anmeldetag: 30.03.2005
(51) Int. Cl.: H01J 37/32

(54) **Vakuumplasmagenerator**
Vacuum plasma generator
Générateur de plasma sous vide

(43) Veröffentlichungstag der Anmeldung: 04.10.2006
(73) Patentinhaber: HÜTTINGER Elektronik GmbH + Co. KG, 79111 Freiburg (DE)
(72) Erfinder: Eyhorn, Thorsten, 79098 Freiburg (DE); Nitschke, Moritz, 79114 Freiburg (DE); Wiedemuth, Peter, 79336 Herbolzheim (DE); Zähringer, Gerhard, 79112 Freiburg (DE)
(74) Vertreter: Kohler Schmid Möbus

(56) Entgegenhaltungen:
- WO-A-03/079397
- DE-A1- 10 260 726
- DE-A1- 10 306 347
- DE-U1- 29 819 336

## Beschreibung

Die Erfindung betrifft einen Vakuumplasmagenerator (VPG) mit einem Ausgangsanschluss zur elektrischen Verbindung des VPGs an mindestens eine Elektrode einer Plasmakammer.

Solche Vakuumplasmageneratoren sind in unterschiedlichen Leistungsklassen und mit unterschiedlichen Signalausgangsformen bekannt. In der Vakuum-Glasbeschichtung werden beispielsweise Generatoren mit DC-Ausgang und MF-Ausgang mit Leistungen zwischen 30 und 300kW eingesetzt. Das MF-Signal ist zumeist ein Sinussignal mit Frequenzen zwischen 10kHz und 200kHz. Die Ausgangsspannungen können dabei mehrere 100V bis über 1000V betragen. Zum Zünden des Plasmas liegen die Spannungen oft noch viel höher als im Normalbetrieb.

Vakuumplasmageneratoren können im Betrieb Störungen verursachen, die die Funktion von anderen Geräten in der Vakuumplasmaanlage stören können. So können Spannungsumformerschaltungen im Vakuumplasmagenerator Oberwellen am Netzeingangsanschluss verursachen, der über den Netzanschluss und das Spannungsversorgungsnetz wiederum auf andere Geräte überkoppelt und diese stört. Auch können beim Zünden des Plasmas hochfrequente Störungen am Ausgangsanschluss des VPGs auftreten. Dabei wirken die Kabel, also die Verbindungskabel vom Ausgang des Generators zu den Elektroden der Plasmakammer, die Kabel zur Fernsteuerung der Generatoren und auch die Netzversorgungskabel als Antennen, die HF-Leistung, die der Generator erzeugt, abstrahlen. Je nach Länge des Ausgangskabels zwischen Generator und Plasmakammer werden solche HF-Störungen in die Umgebung abgegeben und von der Umgebung eingefangen. Sie können daher die Funktion anderer Geräte stören.

Diese Kabel wirken aber auch als Empfangsantennen, das heißt, sie fangen auch HF-Leistung ein und koppeln diese in den Generator und können so seine Funktion stören. Auch hier sind die Länge der Leitungen und die Frequenz der Störungen entscheidend.

Störungen können aber auch direkt von der Netzleitung in den Generator eingekoppelt werden. Diese dürfen die Funktion des Generators möglichst nicht stören.

Schließlich gibt es auch noch Überspannungen, Spannungsabsenkungen und auch kurzzeitige Spannungsunterbrechungen im Spannungsversorgungsnetz, die die Funktion des Generators möglichst nicht beeinflussen sollten.

Aus der DE 298 19 336 U1 ist ein Hochleistungsmittelfrequenzgenerator für Plasmaanlagen bekannt, bei dem der Generator in Netzteil und Oszillatoranordnung aufgeteilt ist, und die Oszillatoranordnung an die äußere Geometrie der Beschichtungskammer angepasst ist und mechanisch und elektrisch unmittelbar mit einem in der Plasmakammer angeordneten Magnetron verbunden ist. Die Länge des Kabels von Oszillator zu Magnetron wird so auf ein Minimum reduziert, allerdings wird stattdessen ein relativ langes Kabel vom Netzteil zur Oszillatoranordnung benötigt, das nun seinerseits Störungen aussenden und einfangen kann.

Aus der WO 03/079397 A1 ist ein Vakuumplasmagenerator mit einem Ausgang zur Speisung einer Plasmaentladung zur Behandlung von Werkstücken in einer Vakuumkammer bekannt geworden. Der Vakuumplasmagenerator umfasst einen Netzanschluss für den Anschluss an ein Wechselspannungsnetz, einen Netzgleichrichter und einen Konverter mit einem Steuereingang zur Einstellung und/oder Regelung der Konverterausgangsspannung.

Aufgabe der vorliegenden Erfindung ist es, einen Vakuumplasmagenerator der eingangs genannten Art so zu verbessern, dass er möglichst störunempfindlich gegen elektromagnetische Strahlung aus der Umwelt ist und zugleich möglichst wenig Strahlung in die Umwelt abgibt. Sollten Störungen zum Ausfall oder zeitlichen Unterbrechungen führen, so sollte gemäß einer Teilaufgabe der VPG diese Zustände anzeigen.

Diese Aufgabe wird durch einen Vakuumplasmagenerator mit den Merkmalen des Anspruchs 1 gelöst.

Dabei können, um die Störunempfindlichkeit zu erhöhen, auch der Netzeingangsfilter, die Spannungsumformersteuerung und ggfs. weitere Elemente des Vakuumplasmagenerators jeweils eine Abschirmung aufweisen. Vorzugsweise sind sie jedoch von einer gemeinsamen Abschirmung, die auch den Spannungsumformer umgibt, umgeben.

Der Netzeingangsfilter schützt vor hochfrequenten Störungen aus dem Spannungsversorgungsnetz und aus der Umgebung, die auf die Netzleitung, d.h. die Verbindungsleitung zwischen Netzanschluss des VPGs und dem Spannungsversorgungsnetz, einkoppeln. Die Bauweise des Netzeingangsfilters kann sehr unterschiedlich sein. Er kann Induktivitäten in Serie zum Netzanschluss sowie Kapazitäten und/oder Überspannungsableiter zu einem Massepotential aufweisen. Der Netzeingangsfilter bedämpft gleichzeitig Störungen vom Generator und verhindert, dass sie auf den Netzleitungen zu Störungen im Spannungsversorgungsnetz führen können und vom Netz in die Umgebung abgestrahlt werden.

Dass Störungen aus der Umgebung nicht auf Komponenten einstrahlen, die nach dem Netzeingangsfilter liegen, kann sichergestellt werden, wenn zumindest der Spannungsumformer, vorzugsweise alle Komponenten, die nach dem Netzeingangsfilter geschaltet sind, abgeschirmt sind. Dazu ist zumindest der Spannungsumformer, vorzugsweise sind alle Komponenten, innerhalb einer Abschirmung, insbesondere einem metallischen Gehäuse, angeordnet. Der Netzeingangsfilter ist vorteilhafterweise sehr nahe an der Abschirmung montiert. Die Netzeingangsleitungen zwischen dem Netzeingangsanschluss und dem Netzeingangsfilter sollten sehr kurz sein. Wenn dies nicht möglich ist, sollten sie geschirmt sein.

Eine als metallisches Gehäuse ausgebildete Abschirmung bietet nicht nur Schutz vor mechanischen Belastungen, sondern es schützt auch vor HF-Strahlung aus der Umgebung und schützt auch die Umgebung vor HF-Strahlung. Alle Filter müssen die HF-Leistung, die sie filtern, abführen. Dazu benötigen sie in der Regel ein festes Massepotential. Das bietet in idealer Weise das metallische Gehäuse, das auch zur Abschirmung verwendet wird. Deshalb ist vorzugsweise eine elektrische Verbindung, insbsondere eine hochfrequent niederohmige Verbindung, zwischen dem Netzeingangsfilter und der Abschirmung vorgesehen.

Mit einer hochfrequent niederohmigen Verbindung ist eine Verbindung zweier Kontaktpunkte gemeint, die niederohmig (< 1 Ohm) für hochfrequente Ströme (> 1kHz insbesondere aber über 1 MHz) ist. Beispielsweise kann das ein breiter, flächig ausgebildeter Leiter mit breiten, flächig ausgebildeten Anschlüssen an den Kontaktpunkten sein. Eine solche Verbindung ist auch für niederfrequente Ströme niederohmig. Eine hochfrequent niederohmige Verbindung kann jedoch auch eine Kapazität sein, mit breiten flächig ausgebildeten Anschlüssen an den Kontaktpunkten, also insbesondere ein wechselstrommäßiger Kurzschluss. Eine solche Verbindung ist für niederfrequente Ströme hochohmig, was in einzelnen Fällen gewünscht sein kann. Ein anderer Begriff für solche Verbindungen ist induktivitätsarme Verbindung.

Die Abschirmung weist erfindungsgemäß eine insbesondere hochfrequent niederohmigen Verbindung zum Rest der Anlage, d.h. zur Plasmakammer, auf. Diese ist idealerweise durch eine möglichst kurze, möglichst breit ausgelegte Verbindung zur Vakuumplasmaanlage, insbesondere zur Plasmakammer, realisierbar. Dazu ist es besonders vorteilhaft, wenn der VPG direkt auf oder in unmittelbarer Nähe zu der Vakuumplasmaanlage aufgestellt werden kann. Ganz besonders vorteilhaft ist die Montage des gesamten Generators auf der Elektrodenhalterung. Dazu weist der gesamte VPG vorteilhafterweise Verbindungselemente zur mechanischen Verbindung mit der Plasmakammer auf. Vorteilhafterweise stellen die Verbindungselemente zur mechanischen Verbindung auch die hochfrequent niederohmige Verbindung her. Möglichst viele, möglichst eng angeordnete Verbindungselemente verbessern den hochfrequenten Kontakt zum Rest der Anlage. Vorteilhaft ist eine breite flächige Verbindung, die durch mehrere Verbindungselemente und ggf. zusätzlich durch Federkontakte abgesichert wird. Erstens wird so eine besonders niederohmige Verbindung hergestellt und zweitens wird so eine besonders kurze Verbindungsleitung zwischen Elektroden und Generator erreicht. Das minimiert die Störempfindlichkeit und die Störabstrahlung. Besonders viele Vorteile erreicht man mit dieser Bauweise bei hohen Ausgangsleistungen, insbesondere bei Ausgangsleistungen größer 30kW, weil hier die Störabstrahlung mit zunehmender Ausgangsspannung ebenfalls zunimmt. Als einzige mögliche Störquellen bleiben nur der Netzanschluss und die Steuerleitungen übrig, die mit dem Generator verbunden werden. Auf den Netzanschluss kann nicht verzichtet werden, deshalb werden Störungen hier mit einem geeigneten oben beschriebenen Netzeingangsfilter unterdrückt.

An dieser Stelle sollte fest gehalten werden, dass die Elektroden der Plasmakammer an einer Elektrodenhalterung befestigt sein können. Elektrodenhalterung und Elektroden werden als Teil der Plasmakammer betrachtet. Vorteilhafterweise kann der Generator mit der Elektrodenhalterung mechanisch verbunden werden, so dass der Generator zusammen mit der Elektrodenhalterung an der übrigen Plasmakammer befestigt werden kann und von dieser gelöst werden kann. Die Verbindungsmittel des Generators mit der Plasma kammer können daher mit den Verbindungselementen zur Verbindung des Generators mit der Elektrodenhalterung übereinstimmen. Die Verbindungsmittel können auch die hochfrequent niederohmige Verbindung der Abschirmung zur Plasmakammer, insbesondere zur Elektrodenhalterung darstellen. Es ist vorteilhaft, wenn die Abmessungen des gesamten VPG an die Abmessungen der Elektrodenhalterung angepasst sind. Oftmals liegen mehrere Elektrodenhalterungen in einer Vakuumplasmaanlage direkt parallel nebeneinander mit einer typischen Breite von ca. 80cm. Wenn jeder Elektrodenhalterung ein VPG zugeordnet wird, im Idealfall direkt auf ihm montiert werden soll, so ist es vorteilhaft, wenn jeder VPG die Breite und die Länge einer Elektrodenhalterung nicht überschreitet. Bei einem auf der Elektrodenhalterung montierten VPG sind mit angepasster Größe die Maße der auf der Elektrodenhalterung liegenden Fläche des VPGs gemeint. Die Höhe des VPGs richtet sich nach den Erfordernissen der Bauhöhe der Anlage. Wenn der Generator nicht direkt auf der Elektrodenhalterung montiert werden soll, z.B. weil ein Wechsel der Elektroden weitaus häufiger stattfindet, als ein Wechsel der Einheit Elektroden, Elektrodenhalterung und VPG, dann ist eine Montage des VPGs in unmittelbarer Nähe mit einer möglichst kurzen Verbindung der Abschirmung zur Plasmakammer besonders vorteilhaft. Bei einer Montage neben oder in unmittelbarer Nähe der Plasmakammer ist es vorteilhaft, wenn wenigstens die Breite angepasst ist, damit auch bei sehr dicht nebeneinander montierten Elektrodenhalterungen für jeder Elektrodenhalterung ein VPG in unmittelbarer Nähe montierbar ist, und bei Austausch der Elektrodenhalterung samt Elektroden auch der VPG mitgetauscht werden kann.

Mit dem Einsatz eines Netzgleichrichters kann das Spannungsversorgungsnetz ein Wechselspannungsnetz mit unterschiedlichen Frequenzen sein, z.B. 50 oder 60Hz. Oberwellen auf dem Netz werden ebenfalls gleichgerichtet und führen zu keinen Störungen im Generator. Das Spannungsversorgungsnetz kann auch ein Gleichspannungsnetz sein, insbesondere ist bei einem Gleichspannungsnetz mit dem Netzgleichrichter ein Verpolschutz realisiert.

Vorteilhafterweise wird eine Gleichrichtung mit Oberwellenunterdrückung, sogenannter Power Factor Correction (PFC), eingesetzt, um möglichst wenig Oberwellen auf dem Stromversorgungsnetz zu erzeugen. Eine solche Oberwellenunterdrückung kann auch dem Netzgleichrichter vor oder nachgeschaltet sein.

Wenn Steuerleitungen und andere Zu- oder Ableitungen ebenfalls geschirmt und/oder mit Eingangsfiltern versehen werden, ist der gesamte VPG optimal gegen Störungen geschützt.

Vorteilhafterweise weist die Abschirmung, insbesondere das metallische Gehäuse, einen Anschluss für eine hochfrequent niederohmige Verbindung an einen Anschluss an der Vakuumplasmaanlage auf, insbesondere an die Elektrodenhalterung, die ihrerseits hochfrequent niederohmig mit der Vakuumplasmaanlage verbindbar ist. Idealerweise kann der Vakuumplasmagenerator direkt an der Elektrodenhalterung montiert werden und so an möglichst vielen Punkten die Abschirmung mit der Elektrodenhalterung verbunden werden. Besonders bevorzugt ist die Abschirmung in ihren Abmessungen an die äußere Gestalt oder Geometrie der Plasma kammer angepasst. Dann kann ein besonders guter elektrischer und/oder mechanischer Kontakt erreicht werden.

Wenn der Plasmagenerator mit der Elektrodenhalterung in einer Einheit fest verbunden ist und zusammen mit dieser an der Vakuumplasmaanlage bzw. Plasmakammer austauschbar ist, dann bleiben die hochfrequent niederohmigen Kontakte erhalten und bieten auch nach einem Tausch der Elektroden-Generatoreinheit einen guten Schutz gegen Störungen.

Vorzugsweise ist eine galvanische Trennung zwischen Netzanschluss und Ausgangsanschluss vorgesehen. Diese dient der störungsfreien Funktion und der Sicherheit. Sie verhindert aber auch die Bildung von Masseschleifen, die ein Grund für die Einkopplung von Störungen darstellen können. Sie sollte insbesondere für hochfrequente Signale, also für Frequenzen deutlich größer als die Betriebsfrequenz eines Mittelfrequenzgenerators (10-500kHz) eine wirkungsvolle Trennung oder Dämpfung darstellen. So kann die Nutzfrequenz übertragen werden, aber hochfrequente Störungen werden sinnvoll unterdrückt.

Vorteilhafterweise ist die Abschirmung mit einem Schutzleiter verbunden, um die Sicherheit für Betreiber und Servicepersonal zu gewährleisten. Mit einem besonders niederohmigen Schutzleiteranschluss können niederfrequente Störungen im Bereich bis zu 10kHz wirkungsvoll bedämpft werden.
Besonders bevorzugt weist der Ausgangsanschluss einen weiteren Anschluss für eine Schirmung für die elektrische Verbindung des Ausgangsanschlusses an die zumindest eine Elektrode auf, die mit der Abschirmung hochfrequent niederohmig verbunden ist. So können Störungen wirkungsvoll unterdrückt werden.

Die Abschirmung ist bevorzugt HF-dicht ausgebildet. Mit HF-dicht ist gemeint, dass sie möglichst wenig HF-Strahlung einlässt und möglichst wenig HF-Strahlung auslässt. Das wird beispielsweise erreicht durch ein vollständig umschließendes metallisches Gehäuse, das möglichst kleine Öffnungen aufweist, insbesondere keine Spalte, die länger sind und keine Öffnungen, die größer sind, als ein zehntel der Wellenlänge der zu dämpfenden Frequenz. Je höher dabei die Frequenz ist, die gedämpft werden soll, desto kleiner ist die Wellenlänge und desto kleiner müssen Gehäuseöffnungen sein. Dies kann z.B. bei Gehäusetüren oder abnehmbaren Öffnungen durch Federkontaktleisten erreicht werden, die mit der Abschirmung bzw. dem metallischen Gehäuse verbunden sind. Bei Öffnungen für Lüftungen sind Lochbleche mit kleinen Löchern Lüftungsschlitzen vorzuziehen.

Besonders bevorzugt ist die elektrische Verbindung des Ausgangsanschlusses an die mindestens eine Elektrode der Vakuumplasmaanlage bzw. der Plasmakammer möglichst kurz, insbesondere kürzer als 2m. Das ist besonders vorteilhaft, weil so besonders wenige Störungen in die Umwelt gelangen und von der Umwelt eingefangen werden.

Bei einer Ausgestaltung der Erfindung ist die Steuerung des VPGs, insbesondere die Spannungsumformersteuerung, digital und weist einen programmierbaren digitalen Logikbaustein auf. Digitale Steuerungen sind besonders unempfindlich gegen Störungen aus der Umwelt und arbeiten besonders zuverlässig.

Besonders vorteilhaft weist der VPG einen Anschluss für eine digitale Fernsteuerleitung auf. Digitale Fernsteuerungen weisen einen besonders guten Störabstand auf und sind sehr unempfindlich gegen Störfelder.
Zudem können auf einer digitalen Fernsteuerleitung Fehlererkennungsdaten mitgesendet werden, so dass man Störungen erkennen kann und die fehlerhaften Daten erneut anfordern kann.

Vorzugsweise weist der Anschluss für die digitale Fernsteuerleitung einen Anschluss für eine Schirmung auf, die eine hochfrequent niederohmige Verbindung zur Abschirmung aufweist. Damit können Störungen weiter unterdrückt werden.

Besonders vorteilhaft weist der Anschluss für eine digitale Fernsteuerleitung eine Verbindung mit der Spannungsumformersteuerung auf. So können die Daten direkt in die Steuerung des Spannungsumformers umgesetzt werden. Besonders vorteilhaft weist diese Verbindung einen Filter zur Unterdrückung von Störungen aus der Umgebung in den Generator und vom Generator in die Umgebung auf. Eine hochfrequent niederohmige Verbindung des Filters zur Abschirmung kann vorgesehen sein. Auf diese Weise wird eine weitere Unterdrückung von Störungen erreicht.

Bei einer Weiterbildung weist die Verbindung des Anschlusses für eine digitale Fernsteuerleitung mit der Spannungsumformersteuerung eine galvanische Trennung auf. So können Masseschleifen verhindert werden, die ein weiterer Grund für die Einkopplung von Störungen sein können.

Besonders vorteilhaft ist der Anschluss für die Fernsteuerleitung ein optischer Anschluss zur Verwendung von Lichtwellenleitern. Optische Leiter verhindern die Einkopplung und die Auskopplung von elektromagnetischen Störungen vollständig und bieten daher den besten Schutz.

Eine Datenübertragung über die Fernsteuerleitung zur Spannungsumformersteuerung und von der Spannungsumformersteuerung ist möglich, wenn der Anschluss für die Fernsteuerleitung bidirektional ist. Es kann eine digitale Regelung vorgesehen werden. Mehrere an der Plasmakammer angeordnete Vakuumplasmageneratoren können so zentral gesteuert und geregelt werden. Insbesondere können der zentralen Steuerung so auch Fehlerzustände angezeigt werden.

Vorteilhafterweise weist der VPG einen Anschluss für externe Analogsignale zur Fernsteuerung des Generators sowie einen internen Analog/Digital-Wandler (A/D Wandler) zur Digitalisierung der externen Analogsignale auf. So können Steuergrößen von einer zentralen Steuerung dem VPG übergeben werden. Der VPG kann die Größen digital und damit störunempfindlich weiterverarbeiten und vorteilhafterweise diese der Spannungsumformersteuerung zuführen.

Vorzugsweise weist auch der Anschluss für externe Analogsignale einen Anschluss für eine Schirmung auf, die eine hochfrequent niederohmige Verbindung zur Abschirmung aufweist.

Besonders vorteilhaft weist der Vakuumplasmagenerator eine Messeinrichtung zur Überwachung der Ausgangsgrößen, wie Ausgangsspannung, Ausgangsstrom und/oder Ausgangsleistung auf, die innerhalb der Abschirmung angeordnet sein kann, und die die Ausgangsgrößen digitalisiert und an die Spannungsumformersteuerung leitet. Damit können die Ausgangsgrößen geregelt, angezeigt, der digitalen Fernsteuerung übergeben, und zu Diagnosezwecken ausgewertet und gespeichert werden.

Fehlmessungen können vermieden werden, wenn die Messeinrichtung Filter zur Unterdrückung von hochfrequenten Störungen aufweist.

Bei einer besonders bevorzugten Ausführungsform weist der Vakuumplasmagenerator einen Transformator mit niedriger kapazitiver Kopplung zur galvanischen Trennung auf. Bekannt ist, dass Transformatoren große Leistungen mit hohem Wirkungsgrad übertragen. Sie können deswegen zur galvanischen Trennung bei Leistungsgeneratoren eingesetzt werden. Vorteilhafterweise sollten diese Transformatoren eine niedrige kapazitive Kopplung aufweisen, insbesondere eine Kopplungskapazität kleiner als 1nF. Die kapazitive Kopplung entsteht durch die Kopplung zwischen Primärwicklung und Sekundärwicklung des Transformators. Um die Kopplung möglichst gering zu halten, müssen die Primärwicklung und die Sekundärwicklung einen möglichst großen Abstand, insbesondere mindesten 5mm voneinander aufweisen. Vorteilhafterweise kann der Transformator auch eine kapazitive Schirmung zwischen Primär- und Sekundärseite aufweisen, die besonders bevorzugt eine Verbindung zur Abschirmung, insbesondere dem metallischen Gehäuse, aufweist.

Besonders vorteilhaft weist der VPG einen Konverter auf, der dem Netzgleichrichter nachgeschaltet ist, und einen Konvertersteuereingang zum Anschluss einer Konvertersteuerung aufweist. An seinem Ausgang liegt typischerweise eine steuerbare Gleichspannung an, die dem Spannungsumformer zugeführt wird. Auf diese Weise können Über- und Unterspannungen am Netz sowie kurzzeitige Netzspannungsunterbrechungen ausgeglichen werden. Der VPG kann folglich trotz der Störungen am Netzeingang ohne Störungen am Ausgang weiterarbeiten.

Besonders vorteilhaft weist der Konverter einen Hochsetzsteller und/oder einen Tiefsetzsteller auf. So kann die steuerbare Gleichspannung eingestellt werden, unabhängig davon, ob die Netzspannung oberhalb oder unterhalb der Gleichspannung liegt. Es wird immer die gewünschte Gleichspannung eingestellt.

Die Konvertersteuerung kann in die Spannungsumformersteuerung integriert sein. So kann die Steuerung und/oder Regelung zentral erfolgen und alle Messwerte und Fehlerzustände können zu Reaktionen an der jeweils richtigen Stelle führen.

In bevorzugter Ausgestaltung der Erfindung weist der Spannungsumformer einen Inverter, der eine pulsförmige bipolare Spannung erzeugt, und einen Resonanzkreis auf, der dem Inverter nachgeschaltet ist, und die pulsförmige Spannung in eine sinusförmige Spannung wandelt. Auf diese Weise werden hohe Frequenzen der pulsförmigen bipolaren Spannung nicht an den Ausgang geleitet. Damit wird die Störabstrahlung des Generators vermindert.

Vorzugsweise weist der VPG eine Fehlerzustandsdiagnoseeinrichtung auf. Fehlerzustände können bei der Überwachung der Ausgangsgrößen ermittelt werden, so kann z.B. ein Arc im Plasma erkannt werden. Aber auch interne Fehlerzustände können erkannt werden, z.B. durch Feuchtesensoren oder Temperatursensoren. Auch kann die interne Gleichspannung am Ausgang des Konverters überwacht werden. Der VPG kann eine Anzeigevorrichtung aufweisen, die diese Fehlerzustände anzeigt.

Wenn eine Speichereinrichtung vorgesehen ist, können die Fehlerzustände im VPG gespeichert und zu Diagnosezwecken angezeigt werden. Sie können über Fernsteuerleitungsanschlüsse auslesbar sein.

Besonders vorteilhaft werden die Fehlerzustände im VPG an den Anschluss zur Fernsteuerleitung geleitet, so kann die zentrale Steuerung die Fehlerzustände auswerten.

Die Fehlerzustandsdiagnoseeinrichtung ist vorzugsweise in die Spannungsumformereinrichtung integriert und nutzt die digitalisierten Daten der Messeinrichtung. So kann in geeigneter Weise auf die Fehlerzustände reagiert werden, z.B die Leistung des Generators begrenzt oder vermindert werden, der VPG ganz oder kurzzeitig abgestellt werden, oder der Spannungsformer so angesteuert werden, dass der Fehlerzustand, z.B. ein Arc im Plasma, möglichst schnell und mit möglichst wenig Energiezufuhr gelöscht wird.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- Fig. 1: ein erstes Ausführungsbeispiel eines Vakuumplasmagenerators mit Plasmakammer;
- Fig. 2a und 2b: ein zweites und ein drittes Ausführungsbeispiel eines Vakuumplasmagenerators mit Elektroden und Elektrodenhalterung;
- Fig. 3: ein Ausführungsbeispiel für einen Spannungsumformer.

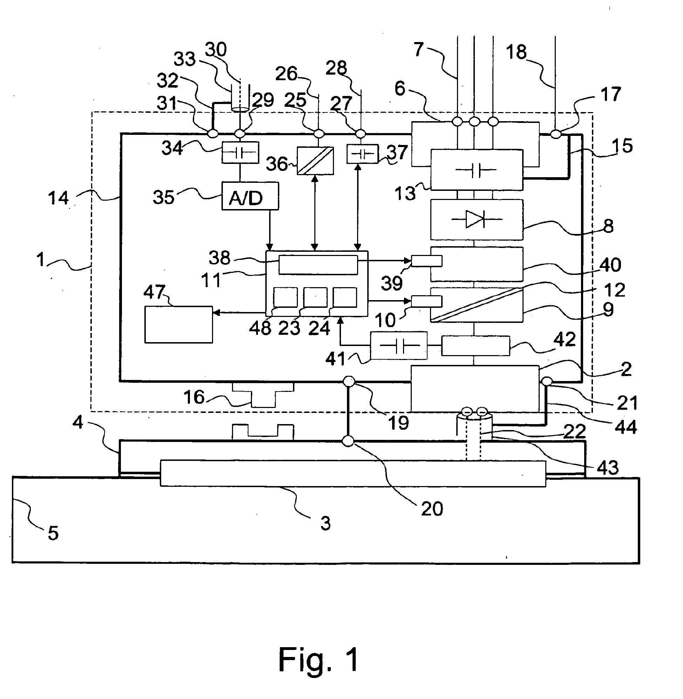

Fig. 1 zeigt einen Vakuumplasmagenerator (VPG) 1 in einer als metallisches Gehäuse ausgebildeten Abschirmung 14, der an einer Plasmakammer 5 einer Vakuumplasmaanlage angeordnet ist. Die Plasmakammer 5 weist eine Elektrodenhalterung 4 auf, in die eine oder mehrere Elektroden 3 montiert sind. Der VPG 1 besitzt einen Ausgangsanschluss 2, an den die Elektroden 3 über eine elektrische Verbindung 22 angeschlossen sind. Diese Verbindung 22 ist im Ausführungsbeispiel sehr kurz, weil der VPG 1 direkt auf der Elektrodenhalterung 4 montiert ist, oder unmittelbar vor der Montage steht. Zusätzlich weist diese Verbindung 22 einen Schirm 43 und eine hochfrequent niederohmige Verbindung 44 von diesem Schirm 43 zu einem Anschluss 21 an der Abschirmung 14 auf. Mit dem Verbindungselement 16, das eine metallische Führung und/oder eine Schraubverbindung sein kann, wird der VPG 1 an die Elektrodenhalterung 4 montiert. Der VPG 1 weist eine Abschirmung 14 auf, die einen Netzeingangsfilter 13, einen Netzgleichrichter 8, einen Spannungsumformer 9 und eine Spannungsumformersteuerung 11 umschließt.

Der Spannungsumformer 9 weist einen Spannungsumformersteuereingäng 10 und eine galvanische Trennung 12 auf. Der Netzeingangsfilter 13 ist über eine hochfrequent niederohmige Verbindung 15 mit der Abschirmung 14 verbunden. Der VPG 1 weist einen Netzanschluss 6 zum Anschluss an das Spannungsversorgungsnetz 7 und einen Schutzleiteranschluss 17 zum Anschluss eines Schutzleiters 18 auf.

Der VPG 1 umfasst einen Anschluss 19 für eine hochfrequent niederohmige Verbindung der Abschirmung 14 mit der Elektrodenhalterung 4 am Anschluss 20. Diese schematisch dargestellte Verbindung kann auch durch Verbindungselemente 16 realisiert werden.

Der VPG 1 weist weiterhin einen Konverter 40 mit einem Konvertersteuereingang 39 zur Steuerung durch eine Konvertersteuerung 38 auf, die im gezeigten Ausführungsbeispiel Teil der Spannungsumformersteuerung 11 ist. Die Spannungsumformersteuerung 11 weist einen digitalen programmierbaren Logikbaustein 23, der in der bekannten Ausführungsform ein DSP (Digitaler Signal Prozessor) ist, und einen Speicherbaustein 24 auf, in dem beispielsweise Fehlerzustände zu Diagnosezwecken gespeichert werden können.

Der VPG 1 weist mehrere Anschlüsse 25, 27, 29 zur Fernsteuerung auf. Die Verbindung vom Anschluss 25 zum Anschluss einer digitalen Fernsteuerleitung 26 zur Spannungsumformersteuerung 11 weist eine Einrichtung 36 zur galvanischen Trennung auf. Die Verbindung vom Anschluss 27 zum Anschluss einer digitalen Fernsteuerleitung 28 zur Spannungsumformersteuerung 11 weist eine Filtereinrichtung 37 auf. Die Fernsteuerleitungen 26, 28 können CAN-Bus, Profibus, RS232, RS485 oder andere digitale bidirektional betreibbare Bussysteme sein. Alle seriellen Bussysteme lassen sich auch über Lichtwellenleiter optisch übertragen. Dann sind die Anschlüsse 25, 27 optische Anschlüsse und auf eine zusätzliche Einrichtung 36 zur galvanischen Trennung und auf einen Filter 37 kann verzichtet werden.

Der Anschluss 29 dient zum Anschluss einer analogen Fernsteuerleitung 30, die im Ausführungsbeispiel eine Schirmung 33 aufweist. Die Schirmung 33 kann mit einer hochfrequent niederohmigen Verbindung 32 an einen Anschluss 31 gekoppelt werden. Die Verbindung vom Anschluss 29 zur Spannungsumformersteuerung 11 weist einen Filter 34 und einen Analog-Digital-Wandler 35 (A/D-Wandler) auf.

Der VPG 1 im Ausführungsbeispiel weist weiterhin eine Messeinrichtung 42 und einen nachgeschalteten Filter 41 auf. Der VPG 1 weist im Ausführungsbeispiel weiter eine Anzeigevorrichtung 47 und eine Fehlerdiagnoseeinrichtung 48, die in der Spannungsumformersteuerung 11 integriert ist, auf.

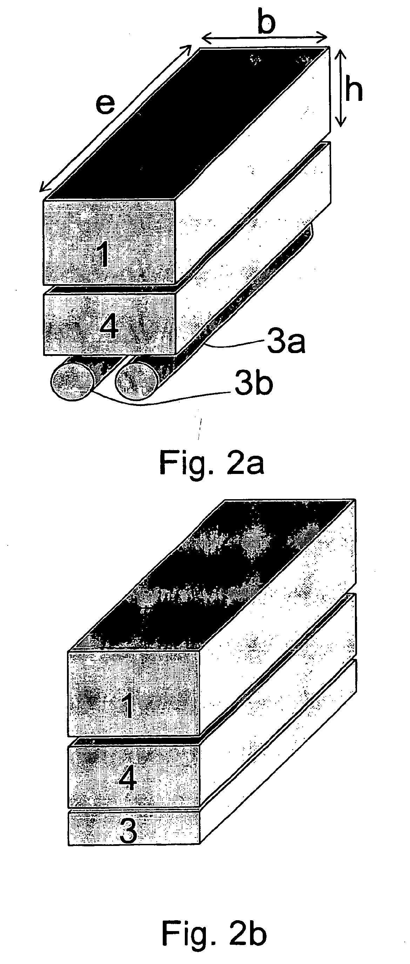

Die Fig. 2a und Fig. 2b sollen noch einmal eine bevorzugte Ausführungsform des VPG 1 mit Elektroden 3, 3a, 3b und Elektrodenhalterung 4 verdeutlichen.

Die Fig. 2a zeigt einen VPG 1 direkt auf der Elektrodenhalterung 4 montiert, an der zwei Elektroden 3a, 3b montiert sind, die im konkreten Ausführungsbeispiel zylinderförmig ausgebildet sind. Der VPG 1 besitzt eine Länge e, die der Länge der Elektrodenhalterung 4 angepasst ist und üblicherweise im Bereich von 2,5m bis 3,5m liegt und eine Breite b, die der Breite der Elektrodenhalterung angepasst ist und im Bereich von 70 bis 80 cm liegt. Die Höhe h kann unabhängig gewählt werden.

Die Fig. 2b zeigt einen VPG 1 direkt auf der Elektrodenhalterung 4 montiert, an der eine planare (flache und breite) Elektrode 3 montiert ist.

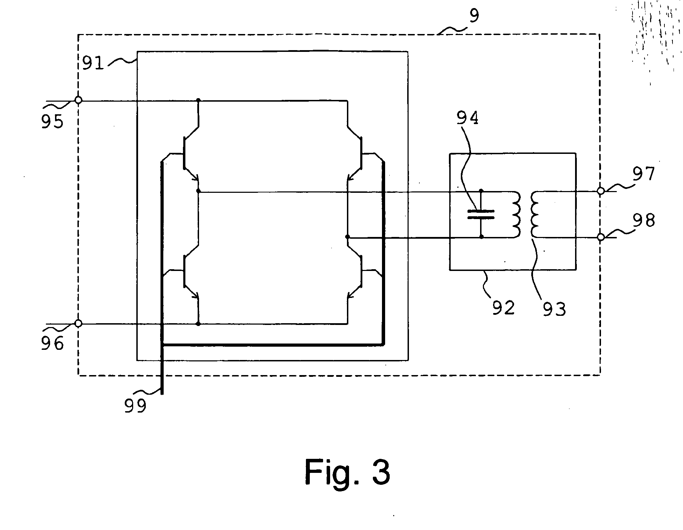

In der Fig. 3 ist eine Ausführungsform für einen Spannungsumformer 9 gezeigt, wie er für einen MF-Generator eingesetzt wird. Er weist zwei Eingangsanschlüsse 95, 96 zum Anschluss des positiven Potentials der Gleichspannung an Anschluss 95 und des negativen Potentials der Gleichspannung an Anschluss 96 auf. Weiter weist er einen Inverter 91 mit einem Anschluss für Steuersignale 99 auf. Zusätzlich weist er einen Resonanzkreis 92 auf, der seinerseits eine Kapazität 94 und einen Transformator 93 aufweist. Die Streuinduktivität des Transformators 93 bildet die Induktivität für den Resonanzkreis 92. Der Transformator 93 stellt die galvanische Trennung sicher. Diese erfolgt vorteilhafterweise möglichst kapazitätsarm, um Störungen aus der Umgebung mit sehr hohen Frequenzen nicht zu dem Inverter gelangen zu lassen. Im Ausführungsbeispiel beträgt die Koppelkapazität 200-500pF. Der Spannungsumformer 9 weist weiterhin zwei Ausgangsanschlüsse 97 und 98 auf, an denen in der gezeigten Ausführungsform ein MF-Signal anliegt.

## Patentansprüche

1. Vakuumplasmagenerator (VPG) (1) mit einem Ausgangsanschluss (2) zur elektrischen Verbindung des VPG (1) an mindestens eine Elektrode (3, 3a, 3b) einer Plasmakammer (5), wobei der VPG (1) einen Netzanschluss (6) zum Anschluss des VPGs an ein Spannungsversorgungsnetz (7), einen Spannungsumformer (9) zur Erzeugung eines Ausgangssignals sowie eine Abschirmung (14), insbesondere ein metallisches Gehäuse, die zumindest den Spannungsumformer (9) umgibt, aufweist, **dadurch gekennzeichnet, dass** der VPG einen Netzeingangsfilter (13) aufweist, der Spannungsumformer (19) einen Spannungsumformersteuereingang (10) zum Anschluss an eine Spannungsumformersteuerung (11) aufweist, und der gesamte Vakuumplasmagenerator (1) Verbindungsmittel zur elektrischen Verbindung, insbesondere hochfrequent niederohmigen Verbindung, der Abschirmung (14) mit der Plasmakammer (5) aufweist.

2. VPG nach Anspruch 1, weiter **dadurch gekennzeichnet, dass** die Verbindungsmittel zur großflächigen Verbindung der Abschirmung des VPGs (1) mit der Plasmakammer (5) ausgebildet sind.

3. VPG nach Anspruch 1 oder 2, weiter **dadurch gekennzeichnet, dass** eine Elektrodenhalterung (4) vorgesehen ist, die unmittelbar mechanisch und/oder elektrisch mit dem VPG (1) verbindbar ist.

4. VPG nach Anspruch 3, weiter **dadurch gekennzeichnet, dass** der VPG (1) an die äußere Gestalt der Elektrodenhalterung (4) angepasst ist und Verbindungselemente (16) zur Montage des VPGs (1) direkt auf der Elektrodenhalterung (4) aufweist.

5. VPG nach einem der vorhergehenden Ansprüche, weiter **dadurch gekennzeichnet, dass** der Netzeingangsfilter (13) mit der Abschirmung (14) insbesondere hochfrequent niederohmig verbunden ist und der Vakuumplasmagenerator (1) einen Schutzleiteranschluss (17) aufweist, der mit der Abschirmung (14) verbunden ist.

6. VPG nach einem der vorhergehenden Ansprüche, weiter **dadurch gekennzeichnet, dass** die Abschirmung (14) einen Anschluss (19) für eine insbesondere hochfrequent niederohmige Verbindung an einen Anschluss (20) an der Plasmakammer (5) aufweist, insbesondere an die Elektrodenhalterung (4), die ihrerseits hochfrequent niederohmig mit der Plasmakammer (5) verbindbar ist.

7. VPG nach einem der vorhergehenden Ansprüche, weiter **dadurch gekennzeichnet, dass** der gesamte Vakuumplasmagenerator (1) Verbindungsmittel zur mechanischen Verbindung des VPGs (1) mit der Plasmakammer (5) aufweist.

8. VPG nach einem der vorhergehenden Ansprüche 4 bis 7, weiter **dadurch gekennzeichnet, dass** die Verbindungselemente (16) die hochfrequent niederohmige Verbindung der Abschirmung (14) des Vakuumplasmagenerators (1) zur Elektrodenhalterung (4) ausbilden.

9. VPG nach einem der vorhergehenden Ansprüche, weiter **dadurch gekennzeichnet, dass** eine elektrische Verbindung (22) des Ausgangsanschlusses (2) an die mindestens eine Elektrode (3, 3a, 3b) der Plasmakammer (5) möglichst kurz, insbesondere kürzer als 2m ist.

10. VPG nach einem der vorhergehenden Ansprüche, weiter **dadurch gekennzeichnet, dass** die Spannungsumformersteuerung (11) als digitale Steuerung ausgebildet ist und einen programmierbaren digitalen Logikbaustein (23) aufweist.

11. VPG nach einem der vorhergehenden Ansprüche, weiter **dadurch gekennzeichnet, dass** wenigstens ein Anschluss (25, 27) für eine digitale Fernsteuerleitung (26, 28) vorgesehen ist.

12. VPG nach Anspruch 11, weiter **dadurch gekennzeichnet, dass** der Anschluss (25, 27) für die digitale Fernsteuerleitung (26, 28) mit der Spannungsumformersteuerung (9) verbunden ist.

13. VPG nach Anspruch 12, weiter **dadurch gekennzeichnet, dass** die Verbindung einen Filter (37), insbesondere zur Unterdrückung von Störungen aus der Umgebung in den VPG (1) und vom VPG (1) in die Umgebung, aufweist und der Filter (37) hochfrequent niederohmig mit der Abschirmung (14) verbunden ist.

14. VPG nach einem der vorhergehenden Ansprüche 12 oder 13, weiter **dadurch gekennzeichnet, dass** die Verbindung des Anschlusses (25) für die digitale Fernsteuerleitung (26) mit der Spannungsumformersteuerung (11) eine galvanische Trennung (36) aufweist.

15. VPG nach einem der vorhergehenden Ansprüche 11 bis 14, weiter **dadurch gekennzeichnet, dass** der Anschluss (25, 27) ein optischer Anschluss und die digitale Fernsteuerleitung (26, 28) ein Lichtwellenleiter ist.

16. VPG nach einem der vorhergehenden Ansprüche 11 bis 15, weiter **dadurch gekennzeichnet, dass** der Anschluss (25, 27) bidirektional ist und eine Datenübertragung über die Fernsteuerleitung (26, 28) zur Spannungsumformersteuerung (11) und von der Spannungsumformersteuerung (11) vorgesehen ist.

17. VPG nach einem der vorhergehenden Ansprüche, weiter **dadurch gekennzeichnet, dass** ein Anschluss (29) für externe Analogsignale zur Fernsteuerung des VPGs (1) und im Innern der Abschirmung (14) ein damit verbundener A/D wandler (35) zur Digitalisierung der externen Analogsignale vorgesehen sind, der mit der Spannungsumformersteuerung (11) verbunden ist.

18. VPG nach einem der vorhergehenden Ansprüche, weiter **dadurch gekennzeichnet, dass** der Vakuumplasmagenerator (1) eine Messeinrichtung (42) zur Überwachung der Ausgangsgrößen, wie Ausgangsspannung, Ausgangsstrom und/oder Ausgangsleistung aufweist, die innerhalb der Abschirmung (14) angeordnet ist und die die Ausgangsgrößen digitalisiert und an die Spannungsumformersteuerung (11) leitet.

19. VPG nach Anspruch 18, weiter **dadurch gekennzeichnet, dass** die Messeinrichtung (42) Filter (41) zur Unterdrückung von hochfrequenten Störungen aufweist.

20. VPG nach einem der vorhergehenden Ansprüche, weiter **dadurch gekennzeichnet, dass** der Vakuumplasmagenerator (1) einen Transformator (93), insbesondere mit geringer kapazitiver Kopplung, zur galvanischen Trennung aufweist.

21. VPG nach einem der vorhergehenden Ansprüche, weiter **dadurch gekennzeichnet, dass** ein Netzgleichrichter (13) vorgesehen ist, dem ein Konverter (40) nachgeschaltet ist, der einen Konvertersteuereingang (39) zum Anschluss einer Konvertersteuerung (38) aufweist, wobei der Ausgang des Konverters (40) mit dem Spannungsumformer (9) verbunden ist.

22. VPG nach Anspruch 21, weiter **dadurch gekennzeichnet, dass** der Konverter (40) einen Hochsetzsteller und/oder Tiefsetzsteller aufweist.

23. VPG nach einem der vorhergehenden Ansprüche 21 oder 22, weiter **dadurch gekennzeichnet, dass** die Konvertersteuerung (38) in die Spannungsumformersteuerung (11) integriert ist.

24. VPG nach einem der vorhergehenden Ansprüche, weiter **dadurch gekennzeichnet, dass** der Spannungsumformer (9) einen Inverter, der eine pulsförmige Wechselspannung erzeugt, und einen Resonanzkreis aufweist, der dem Inverter nachgeschaltet ist und die pulsförmige Spannung in eine sinusförmige Spannung wandelt.

25. VPG nach einem der vorhergehenden Ansprüche, weiter **dadurch gekennzeichnet, dass** der VPG (1) eine Fehlerzustandsdiagnoseeinrichtung (48) und eine Anzeigevorrichtung (47) aufweist, die Fehlerzustände anzeigt.

26. VPG nach einem der vorhergehenden Ansprüche, weiter **dadurch gekennzeichnet, dass** der VPG (1) einen Speicher (24) aufweist, in dem die Fehlerzustände speicherbar sind und zu Diagnosezwecken auslesbar und auf der Anzeigevorrichtung (47) anzeigbar oder über Fernsteuerieifiungsanschlüsse (25, 27) auslesbar sind.

27. VPG nach einem der vorhergehenden Ansprüche 25 oder 26, weiter **dadurch gekennzeichnet, dass** eine Fehlerzustandsdiagnoseeinrichtung (48) in die Spannungsumformersteuerung (11) integriert ist und ihr die digitalisierten Daten der Messeinrichtung (42) zugeführt sind.

## Claims

1. A vacuum plasma generator (VPG) (1) having an output connector (2) for electrical connection of the VPG (1) to at least one electrode (3, 3a, 3b) of a plasma chamber (5), wherein the VPG (1) comprises a mains connector (6) for connection of the VPG to a mains power supply (7), a voltage converter (9) for generating an output signal, and a shield (14), in particular a metallic housing, which surrounds at least the voltage converter (9), **characterised in that** the VPG has a mains input filter (13), the voltage converter (19) has a voltage converter control input (10) for connection to a voltage converter control (11), and the vacuum plasma generator (1) in its entirety has connection means for electrical connection, in particular low impedance to high frequency connection, of the shield (14) to the plasma chamber (5).

2. A VPG according to claim 1, further **characterised in that** the connection means are configured for connection of the shield of the VPG (1) to the plasma chamber (5) over a large surface area.

3. A VPG according to claim 1 or claim 2, further **characterised in that** an electrode holder (4) is provided which is mechanically and/or electrically directly connectable to the VPG (1).

4. A VPG according to claim 3, further **characterised in that** the VPG (1) is matched to the external shape of the electrode holder (4) and has connection elements (16) for mounting of the VPG (1) directly on top of the electrode holder (4).

5. A VPG according to any one of the preceding claims, further **characterised in that** the mains input filter (13) is connected to the shield (14), in particular with low impedance to high frequency, and the vacuum plasma generator (1) has a protective earth conductor connector (17) which is connected to the shield (14).

6. A VPG according to any one of the preceding claims, further **characterised in that** the shield (14) has a connector (19) for a connection, in particular a low impedance to high frequency connection, to a connector (20) on the plasma chamber (5), in particular to the electrode holder (4) which is in turn connectable to the plasma chamber (5) with low impedance to high frequency.

7. A VPG according to any one of the preceding claims, further **characterised in that** the vacuum plasma generator (1) in its entirety has connection means for mechanical connection of the VPG (1) to the plasma chamber (5).

8. A VPG according to any one of preceding claims 4 to 7, further **characterised in that** the connection elements (16) form the low impedance to high frequency connection of the shield (14) of the vacuum plasma generator (1) to the electrode holder (4).

9. A VPG according to any one of the preceding claims, further **characterised in that** an electrical connection (22) of the output connector (2) to the at least one electrode (3, 3a, 3b) of the plasma chamber (5) is as short as possible, in particular shorter than 2 m.

10. A VPG according to any one of the preceding claims, further **characterised in that** the voltage converter control (11) is in the form of a digital control and has a programmable digital logic device (23).

11. A VPG according to any one of the preceding claims, further **characterised in that** at least one connector (25, 27) for a digital remote control line (26, 28) is provided.

12. A VPG according to claim 11, further **characterised in that** the connector (25, 27) for the digital remote control line (26, 28) is connected to the voltage converter control (9).

13. A VPG according to claim 12, further **characterised in that** the connection has a filter (37), in particular for suppression of interference from the surroundings into the VPG (1) and from the VPG (1) into the surroundings, and the filter (37) is connected to the shield (14) with low impedance to high frequency.

14. A VPG according to either of preceding claims 12 and 13, further **characterised in that** the connection of the connector (25) for the digital remote control line (26) to the voltage converter control (11) has a galvanic separation (36).

15. A VPG according to any one of preceding claims 11 to 14, further **characterised in that** the connector (25, 27) is an optical connector and the digital remote control line (26, 28) is an optical waveguide.

16. A VPG according to any one of preceding claims 11 to 15, further **characterised in that** the connector (25, 27) is bidirectional and data transfer to the voltage converter control (11) and from the voltage converter control (11) via the remote control line (26, 28) is provided.

17. A VPG according to any one of the preceding claims, further **characterised in that** a connector (29) is provided for external analogue signals for remote control of the VPG (1) and, connected therewith, an A/D converter (35) for digitizing the external analogue signals is provided inside the shield (14), which A/D converter (35) is connected to the voltage converter control (11).

18. A VPG according to any one of the preceding claims, further **characterised in that** the vacuum plasma generator (1) has a measuring device (42) for monitoring the output quantities, such as output voltage, output current and/or output power, which is disposed inside the shield (14) and which digitizes the output quantities and passes them to the voltage converter control (11).

19. A VPG according to claim 18, further **characterised in that** the measuring device (42) has filters (41) for suppressing high-frequency interference.

20. A VPG according to any one of the preceding claims, further **characterised in that** the vacuum plasma generator (1) has a transformer (93), in particular with low-capacitance coupling, for galvanic separation.

21. A VPG according to any one of the preceding claims, further **characterised in that** a mains rectifier (13) is provided, wherein a converter (40) is connected downstream of the mains rectifier (13), which converter (40) has a converter control input (39) for connection of a converter control (38), the output of the converter (40) being connected to the voltage converter (9).

22. A VPG according to claim 21, further **characterised in that** the converter (40) has a boost converter and/or a buck converter.

23. A VPG according to either of preceding claims 21 and 22, further **characterised in that** the converter control (38) is integrated in the voltage converter control (11).

24. A VPG according to any one of the preceding claims, further **characterised in that** the voltage converter (9) has an inverter, which generates a pulse-shaped AC voltage, and a resonant circuit, which is connected downstream of the inverter and which converts the pulse-shaped voltage into a sinusoidal voltage.

25. A VPG according to any one of the preceding claims, further **characterised in that** the VPG (1) has an error condition diagnosis device (48) and an indicating device (47) which indicates error conditions.

26. A VPG according to any one of the preceding claims, further **characterised in that** the VPG (1) has a memory (24) in which the error conditions may be stored and read out for diagnostic purposes and indicated on the indicating device (47) or read out *via* remote control line connectors (25, 27).

27. A VPG according to either of preceding claims 25 and 26, further **characterised in that** an error condition diagnosis device (48) is integrated in the voltage converter control (11) and the digitized data of the measuring device (42) are fed to it.

## Revendications

1. Générateur de plasma sous vide (VPG) (1) avec un raccordement de sortie (2) pour la liaison électrique du VPG (1) à au moins une électrode (3, 3a, 3b) d'une chambre à plasma (5), le VPG (1) présentant un raccordement au secteur (6) pour raccorder le VPG à un réseau d'alimentation électrique (7), un convertisseur de tension (9) pour générer un signal de sortie, ainsi qu'un blindage (14), en particulier un boîtier métallique qui entoure au moins le convertisseur de tension (9), **caractérisé en ce que** le VPG présente un filtre d'entrée secteur (13), que le convertisseur de tension (9) présente une entrée de commande de convertisseur de tension (10) pour le raccordement à une commande de convertisseur de tension (11) et que le générateur de plasma sous vide (1) dans son ensemble présente des moyens de connexion pour la liaison électrique, en particulier la liaison à haute fréquence et basse impédance, du blindage (14) avec la chambre à plasma (5).

2. VPG selon la revendication 1, **caractérisé de plus en ce que** les moyens de connexion sont conçus pour la liaison à grande surface du blindage du VPG (1) avec la chambre à plasma (5).

3. VPG selon la revendication 1 ou 2, **caractérisé de plus en ce qu'**il est prévu un porte-électrode (4) qui peut être relié directement mécaniquement et/ou électriquement avec le VPG (1).

4. VPG selon la revendication 3, **caractérisé de plus en ce que** le VPG (1) est adapté à la forme extérieure du porte-électrode (4) et présente des éléments de connexion (16) pour le montage du VPG (1) directement sur le porte-électrode (4).

5. VPG selon une des revendications précédentes, **caractérisé de plus en ce que** le filtre d'entrée secteur (13) est relié au blindage (14), en particulier à haute fréquence et basse impédance, et que le générateur de plasma sous vide (1) présente un raccordement de conducteur de protection (17) qui est relié au blindage (14).

6. VPG selon une des revendications précédentes, **caractérisé de plus en ce que** le blindage (14) présente un raccordement (19) pour une liaison, en particulier à haute fréquence et basse impédance, à un raccordement (20) sur la chambre à plasma (5), en particulier sur le porte-électrode (4), qui lui-même peut être relié à haute fréquence et basse impédance à la chambre à plasma (5).

7. VPG selon une des revendications précédentes, **caractérisé de plus en ce que** le générateur de plasma sous vide (1) dans son ensemble présente des moyens de connexion pour la liaison mécanique du VPG (1) avec la chambre à plasma (5).

8. VPG selon une des revendications précédentes 4 à 7, **caractérisé de plus en ce que** les éléments de liaison (16) forment la liaison à haute fréquence et basse impédance du blindage (14) du générateur de plasma sous vide (1) avec le porte-électrode (4).

9. VPG selon une des revendications précédentes, **caractérisé de plus en ce qu'**une liaison électrique (22) du raccordement de sortie (2) à ladite au moins une électrode (3, 3a, 3b) de la chambre à plasma (5) est la plus courte possible, en particulier plus courte que 2 m.

10. VPG selon une des revendications précédentes, **caractérisé de plus en ce que** la commande de convertisseur de tension (11) est réalisée sous forme de commande numérique et présente un composant logique numérique programmable (23).

11. VPG selon une des revendications précédentes, **caractérisé de plus en ce qu'**il est prévu au moins un raccordement (25, 27) pour une ligne de commande à distance numérique (26, 28).

12. VPG selon la revendication 11, **caractérisé de plus en ce que** le raccordement (25, 27) pour la ligne de commande à distance numérique (26, 28) est relié à la commande de convertisseur de tension (9).

13. VPG selon la revendication 12, **caractérisé de plus en ce que** la liaison présente un filtre (37), en particulier pour supprimer les perturbations de l'environnement dans le VPG (1) et du VPG (1) dans l'environnement et que le filtre (37) est relié à haute fréquence et basse impédance avec le blindage (14).

14. VPG selon une des revendications précédentes 12 ou 13, **caractérisé de plus en ce que** la liaison du raccordement (25) pour la ligne de commande à distance numérique (26) avec la commande de convertisseur de tension (11) présente une séparation galvanique (36).

15. VPG selon une des revendications précédentes 11 à 14, **caractérisé de plus en ce que** le raccordement (25, 27) est un raccordement optique et la ligne de commande à distance numérique (26, 28) un câble à fibres optiques.

16. VPG selon une des revendications précédentes 11 à 15, **caractérisé de plus en ce que** le raccordement (25, 27) est bidirectionnel et qu'il est prévu une transmission de données par la ligne de commande à distance (26, 28) vers la commande de convertisseur de tension (11) et de la commande de convertisseur de tension (11).

17. VPG selon une des revendications précédentes, **caractérisé de plus en ce qu'**il est prévu un raccordement (29) pour des signaux analogiques externes pour la commande à distance du VPG (1) et, à l'intérieur du blindage (14), un convertisseur A/N (35) relié à celui-ci pour numériser les signaux analogiques externes, qui est relié à la commande de convertisseur de tension (11).

18. VPG selon une des revendications précédentes, **caractérisé de plus en ce que** le générateur de plasma sous vide (1) présente un dispositif de mesure (42) pour surveiller les grandeurs de sortie, comme la tension de sortie, le courant de sortie et/ou la puissance de sortie, qui est disposé à l'intérieur du blindage (14) et transmet les grandeurs de sortie numérisées à la commande de convertisseur de tension (11).

19. VPG selon la revendication 18, **caractérisé de plus en ce que** le dispositif de mesure (42) présente des filtres (41) pour supprimer les perturbations à haute fréquence.

20. VPG selon une des revendications précédentes, **caractérisé de plus en ce que** le générateur de plasma sous vide (1) présente un transformateur (93), en particulier à faible couplage capacitif, pour la séparation galvanique.

21. VPG selon une des revendications précédentes, **caractérisé de plus en ce qu'**il est prévu un redresseur de secteur (13), en aval duquel est placé un convertisseur (40) qui présente une entrée de commande de convertisseur (39) pour le raccordement d'une commande de convertisseur (38), la sortie du convertisseur (40) étant reliée au convertisseur de tension (9).

22. VPG selon la revendication 21, **caractérisé de plus en ce que** le convertisseur (40) présente un transformateur élévateur et/ou un transformateur abaisseur.

23. VPG selon une des revendications précédentes 21 ou 22, **caractérisé de plus en ce que** la commande de convertisseur (38) est intégrée dans la commande de convertisseur de tension (11).

24. VPG selon une des revendications précédentes, **caractérisé de plus en ce que** le convertisseur de tension (9) présente un onduleur qui génère une tension alternative en forme d'impulsions et un circuit résonnant qui est placé en aval de l'onduleur et qui convertit la tension en forme d'impulsions en une tension sinusoïdale.

25. VPG selon une des revendications précédentes, **caractérisé de plus en ce que** le VPG (1) présente un dispositif de diagnostic d'états d'erreur (48) et un dispositif d'affichage (47) qui affiche les états d'erreur.

26. VPG selon une des revendications précédentes, **caractérisé de plus en ce que** le VPG (1) présente une mémoire (24) dans laquelle les états d'erreur peuvent être mémorisés et lus aux fins de diagnostic et affichés sur le dispositif d'affichage (47) ou lus via les raccordements de ligne de commande à distance (25, 27).

27. VPG selon une des revendications précédentes 25 ou 26, **caractérisé de plus en ce qu'**un dispositif de diagnostic d'états d'erreur (48) est intégré dans la commande de convertisseur de tension (11) et que les données numérisées du dispositif de mesure (42) lui sont amenées.
